Europäisches Patentamt

European Patent Office

Office européen des brevets

(11) Publication number: **0 391 123**
**A2**

# EUROPEAN PATENT APPLICATION

(21) Application number: 90105225.8

(22) Date of filing: 20.03.90

(51) Int. Cl.⁵: **H01L 21/3205**

The title of the invention has been amended (Guidelines for Examination in the EPO, A-III, 7.3).

(30) Priority: **04.04.89 US 333159**

(43) Date of publication of application:
**10.10.90 Bulletin 90/41**

(84) Designated Contracting States:
**DE FR GB IT NL**

(71) Applicant: **TEXAS INSTRUMENTS INCORPORATED**
**13500 North Central Expressway**
**Dallas Texas 75265(US)**

(72) Inventor: **Havemann, Robert, H.**
**7413 Stillwater Court**
**Garland, Texas 75042(US)**
Inventor: **Eklund, Robert H.**
**1121 Joshua Tree Drive**
**Plano, Texas 75023(US)**

(74) Representative: **Leiser, Gottfried, Dipl.-Ing.**
**Patentanwälte Prinz, Leiser, Bunke & Partner**
**Manzingerweg 7**
**D-8000 München 60(DE)**

(54) **Extended length trench resistor and capacitor.**

(57) A resistive element (10) and method for constructing the same is provided which includes a trench (12) formed in an underlying layer (14). A resistive layer (26) is formed within trench (12) and separated therefrom by an insulating layer (24). Tabs (30,32) may be formed at the ends (44,46) of resistive layer (26). An insulating region (38) may be formed in either void area (27) or (36). A capacitance may also be realized where the underlying layer (14) is a conductor thereby enclosing a dielectric (insulating layer (24)) between itself and resistive layer (26).

FIG. 4

# EXTENDED LENGTH TRENCH RESISTOR

## RELATED APPLICATION

This Application is related to co-pending Application for United States Letters Patent Serial No. (Attorney's docket No. TI-13000), filed contemporaneously herewith, entitled "Integrated Circuit Trench Resistor."

## TECHNICAL FIELD OF THE INVENTION

This invention relates to integrated circuits, and more particularly to a resistor formed within a trench associated with an integrated circuit.

## BACKGROUND OF THE INVENTION

As integrated circuit technology advances, the size of components decrease while the packing density of components on a single chip increases. Increased packing density renders surface area on the chip more valuable. Consequently, any resistors used within the integrated circuit are more favorably constructed in a smaller lateral area and with minimum consumption of surface area. Further, capacitive effects associated with the resistor are preferably minimized.

Resistors used in current integrated circuits typically comprise isotropically diffused regions within a semiconductor layer or substrate. These resistors are commonly formed by ion implantation within a semiconductor device. The resistance of these devices is given by,

$$R = R_s \left( \frac{1}{w} \right),$$

where, R is resistance,
$R_s$ is the sheet resistance of the diffused region,
l is the length of the resistive region, and
w is the width of the resistive region.

Thus, to achieve higher resistance values, one must increase the length or decrease the width of the resistive region. However, width is limited to approximately 2 $\mu$m due to the tolerance to which line widths can be held. Thus, any further increase in resistance must be accomplished by increasing length. Increasing the length increases the surface area consumed by the resistor. As a result, less surface area remains for the formation of additional devices thereon. Capacitive effects may also arise due to construction of the diffused resistor which necessarily includes a PN junction. If the resistor is to be connected to a device isolated from other devices, then a contact must run from the resistor to the isolated device, thereby creating additional capacitance problems.

Therefore, a need has arisen for a resistor which may be utilized within an integrated circuit to provide a desirable resistance within a limited area on the chip. Further, the resistor should minimize the capacitance attributable to the resistor interface with surrounding semiconductor regions. There also arises a need to provide minimum capacitance when coupling the resistor to a device isolated from other devices within the integrated circuit.

## SUMMARY OF THE INVENTION

In accordance with the present invention, a resistive element and a method of constructing the same are provided which substantially eliminate or reduce disadvantages and problems associated with prior integrated circuit resistors.

A resistive element in accordance with the present invention includes a first layer of material having a trench formed therein. A conformal layer of resistive material lies adjacent the trench in a serpentine-like manner, that is, down one sidewall, across the bottom edge and up another sidewall of the trench. An insulating layer may also be placed between the conformal layer of resistive material and the trench. The conformal layer defines a void area within the trench and this void area may be filled with an insulating region. A thin insulating layer may be deposited or thermally grown within the void area prior to the formation of this insulating region. Pads may also be formed adjacent the ends of the resistive conformal layer in order to provide electrical contact thereto. Where the first layer is a conductive material, a capacitance may also be associated with the resistive element. The capacitance arises due to the insulating layer being formed between the resistive material and the conductive first layer.

The present invention provides the technical advantages of minimizing the surface area needed for a resistive element. Another technical advantage of the present invention is the reduction of capacitance associated with the resistive element. The present invention also includes the technical advantage of permitting a resistive element to be directly connected to a device which is isolated from other devices where that isolation is accomplished by use of a trench.

## BRIEF DESCRIPTION OF THE DRAWINGS

For a more complete understanding of the present invention and the advantages thereof, reference is now made to the following descriptions taken in conjunction with the accompanying drawings, in which:

FIGURE 1 illustrates a cross-sectional view of a layer of resistive material formed within a trench;

FIGURE 2a illustrates a cross-sectional view of a resist pattern formed over the layer of resistive material;

FIGURE 2b illustrates a plan view of the resist pattern of FIGURE 2a;

FIGURE 3 illustrates a cross-sectional view of the resistive layer following patterning of tabs thereon;

FIGURE 4 illustrates a cross-sectional view of the resistive layer having an insulating region formed within the void created by the resistive layer;

FIGURE 5 illustrates a plan view of an alternative embodiment of the present invention; and

FIGURE 6 illustrates a plan view of the resistive element of the present invention being used to contact a trench-isolated device.

## DETAILED DESCRIPTION OF THE INVENTION

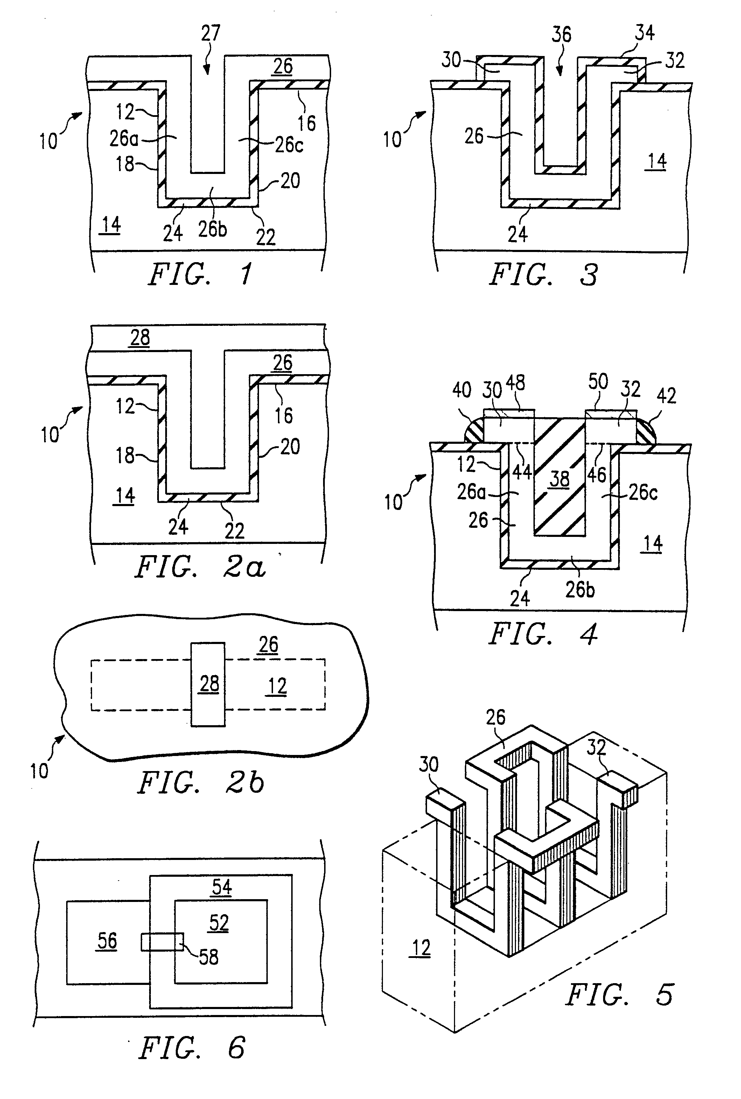

The preferred embodiment of the present invention is best understood by referring to FIGUREs 1-6 of the drawings, like numerals being used for like and corresponding parts of the various drawings.

FIGURE 1 illustrates a cross-sectional view of the resistor 10 of the present invention after a first processing stage. A trench 12 is formed within a layer 14. In integrated circuit processing, layer 14 typically comprises a layer of semiconductor material such as silicon.

Trench 12 may be etched downwardly from the surface 16 of layer 14 or, alternatively, etched through a field insulating region (not shown) existing at surface 16. The formation of trench 12 creates sidewalls 18 and 20 and a bottom edge 22. The depth of trench 12 is defined as the distance from surface 16 to bottom edge 22 and is typically on the order of 1 μm to 10 μm. The width of trench 12 is defined as the distance between sidewalls 18 and 20. Typically, this width is on the order of 1 μm to 3 μm.

An insulating layer 24 may be formed along sidewalls 18 and 20 and bottom edge 22 of trench 12. Typically, insulating layer 24 comprises an oxide on the order of 500-2500 angstroms. Increasing the thickness of insulating layer 24 will reduce the capacitance associated with resistor 10. Resistive layer 26 is formed within trench 12 adjacent insulating layer 24. Accordingly, resistive layer 26 lies in a serpentine-like manner within trench 12, dipping parallel to sidewalls 18 and 20 and bottom edge 22. Thus, resistive sidewalls 26a and 26c, along with a resistive bottom layer 26b, are formed within trench 12. A void area 27 is defined within trench 12 by the creation of resistive layer 26 therein. Resistive layer 26 comprises any material of known resistivity, such that the resistance of resistor 10 may be accurately calculated. In the instance of an integrated circuit, resistive layer 26 may be deposited doped silicon such as amorphous polycrystalline or recrystallized silicon. Further, resistive layer 26 may be a conformal layer thus ensuring that the cross-sectional dimensions thereof are uniform, thereby further permitting accurate predictability as to the resistance thereof. More particularly, resistance is defined by the following equation:

$$R = \frac{(\rho)(\ell)}{A},$$

where, R is resistance

$\rho$ is the resistivity of the resistive material,

$\ell$ is length of the resistive material, and

A = the cross-sectional area of the resistive material.

The use of a conformal layer gives rise to a uniform cross-sectional area and therefore, further knowledge of the length and resistivity of resistive layer 26 assures accurate prediction of the resistance of that layer.

It should also be noted that the thickness (i.e. height above surface 16) of resistive layer 26 must be less than one-half of the width of trench 12. This ensures that some void area 27 will exist, thereby preventing contact between resistive sidewalls 26a and 26c. Further, where insulating layer 24 is used, the thickness of resistive layer must be less than one-half of the distance between the opposing layers of insulating layer 24 adjacent sidewalls 18 and 20. Again, this provides for some void area 27 within trench 12.

FIGURE 2a illustrates resistor 10 of the present invention having a resist pattern 28 placed thereover. Resist pattern 28 will also act to fill void area 27. Resist pattern 28 is typically a photosensitive resist which will mask materials lying thereunder during a suitable etch process. FIGURE 2b illustrates a plan vew of resistor 10 illustrated in FIGURE 2a. From this perspective, it may be appreciated that resist pattern 28 overlies resistive layer 26 formed within trench 12 and at surface 16 of layer 14 (see FIGURE 2). An etch performed on the configuration depicted in FIGURE 2b will remove all resistive layer 26 not protected by resist pattern 28. Thus, a resistive layer will be formed within trench 12 in a manner generally perpendicular thereto. It should also be noted that a plurality of resist patterns could be formed rather than a single pattern 28 as shown in FIGURE 2b. As a result, a subsequent etch would create numerous generally parallel resistive layers within trench 12.

FIGURE 3 illustrates resistor 10 of the present invention following an etch of the resistive material and the removal of resist pattern 28. The etch removes excess resistive material associated with resistive layer 26 both within trench 12 and overlying surface 16 and insulating layer 24. Note that first and second tabs 30 and 32, respectively, part of resistive layer 26 which remains above surface 16 and overlies insulating layer 24, are also formed. A thin insulating layer 34 may be formed along resistive layer 26 within void area 27 (see FIGURE 1) and along tabs 30 and 32. Thin insulating layer 34 will thus define a second void area 36 which is slightly narrower than void area 27 (see FIGURE 1). Typically, thin insulating layer 34 is formed by growing an oxide along resistive layer 26. This oxide layer is typically on the order of 100-500 angstroms in thickness. Thin insulating layer 34 provides a seal for minimizing the effect of impurities on resistive layer 26 which may otherwise contact that layer during subsequent processing steps.

FIGURE 4 illustrates resistor 10 of the present invention having an insulating region 38 added thereto. Thin insulating layer 34, discussed in connection with FIGURE 3, is omitted in FIGURE 4, but may optionally be used therewith. The formation of insulating region 38 also forms sidewall insulators 40 and 42. Insulating region 38 and sidewall insulators 40 and 42 may be formed by applying a conformal insulating layer over the device depicted in FIGURE 3 and anisotropically etching that layer, yielding the device depicted in FIGURE 4. Typically, this insulating layer may comprise either TEOS or a composite TEOS/polysilicon sandwich.

Where resistive layer 26 comprises a semiconductor, tabs 30 and 32 may be more heavily doped than resistive layer 26. The higher dopant concentration provides areas where low resistance contacts may be formed. For example, if resistive layer 26 were of a P type semiconductor material, then additional dopants such as boron, gallium or aluminum could be applied to tabs 30 and 32 to increase their dopant concentration, thereby permitting a lesser resistance contact to resistive layer 26. A typical high dopant concentration would be greater than $10^{18}/cm^3$. Doping of tabs 30 and 32 defines the ends 44 and 46 of resistive material 26. Thus, the length of resistive material 26 (i.e. the length between end 44 and end 46) may be more accurately predicted for calculating resistance in connection with the aforementioned resistance equation. Silicided contacts 48 and 50 may be added to tabs 30 and 32, respectively, in order to provide electrical contact to resistive layer 26.

The structure of the present invention may also be used to implement a capacitor, as shown in FIGURE 4. A capacitor is formed using the present invention in the instance where layer 14 comprises a conductive material. In this instance, the conductive material and conformal layer 26 have a dielectric material (i.e. insulating layer 24) therebetween. As such, there exists, in order, a first conductor (layer 14), a dielectric material (insulating layer 24), and a second conductor (resistive material 26). Thus, a capacitive element exists within the present invention, or alternatively, a capacitor in parallel with the resistor herein described. By contacting tabs 30 and 32, there will be both a resistance and capacitance existing between those contacts. Further, by varying the width of insulating layer 24, the capacitance associated therewith will also vary. Thus, the present invention includes a resistive/capacitive element having both a variable resistance and a varying capacitance.

FIGURE 5 illustrates a perspective view of an alternative embodiment of the present invention. From this perspective, it may be appreciated that resistive layer 26 may be patterned in accordance with the processes described above such that resistive layer 26 winds through trench 12 in a back-and-forth manner. Thus, rather than having a single resistive bottom layer 26b (see FIGURE 1), there may be a plurality of such layers going back and forth within trench 12 to accomplish a desirable length. This length will give rise to a resistance calculated in accordance with the aforementioned resistance equation. Again, tabs 30 and 32 may be formed at the ends of resistive layer 26 such that contact may be made to resistive layer 26. It may thus be appreciated that a long resistor may be constructed in accordance with the present invention while expending very little surface area of the material in which the trench is formed. Further, the length of the resistor is constrained only by the dimensions of the trench itself rather than the available surface area of the device.

FIGURE 6 illustrates another aspect of the present invention. A plan view is shown of an integrated circuit component 52 isolated by a trench 54 from neighboring circuitry 56. Where component 52 and circuitry 56 were connected by a resistor in the past, that resistor was constructed near one or the other device and a interconnect was formed therebetween. However, this contact gives rise to capacitance which will adversely affect both components. With the present invention, a resistor 58 may be formed along and within the trench as described above, while further connecting component 52 with circuitry 56. Again, resistor 58 may be fashioned of any length necessary to provide the requisite resistance therefor. Therefore, the present invention may further ieduce capacitance effects associated with prior art integrated circuit resistors. Furthermore, because resistor 58 is formed within trench 54, trench 54 serves as both an isolation device as well as a passive element (i.e. the resistor). Thus, less surface area is required in comparison to prior art circuits. Still further, closer packing density is permitted by this approach.

Although the preferred embodiment of the present invention has been described in detail, it should be understood that various changes, substitutions and alterations can be made thereto without departing from the spirit and scope of the invention as further defined by the appended claims.

## Claims

1. A resistive element, comprising:
A first layer of material having a trench formed therein, said trench of a predetermined width and having first and second sidewalls and a bottom edge; and
a layer of resistive material adjacent said sidewalls and said bottom edge of said trench defining a void area within said trench.

2. The resistive element of Claim 1 wherein said layer of resistive material comprises a conformal layer of resistive material, said conformal layer of a thickness less than one-half of said predetermined width.

3. The resistive element of Claim 1 and further comprising an insulating layer disposed between said layer of resistive material and said sidewalls of said trench.

4. The resistive element of Claim 1 and further comprising an insulating layer disposed between said layer of resistive material and said bottom edge of said trench.

5. The resistive element of Claim 1 wherein said void area comprises a first void area, and further comprising an insulating layer within said first void area and adjacent said layer of resistive material, defining a second void area.

6. A capacitive element, comprising:
a layer of a first conductive material having a trench formed therein, said trench of a predetermined width and having first and second sidewalls and a bottom edge;
a layer of a second conductive material adjacent one of said sidewalls of said trench, said layer of a second conductive material of a thickness less than one- half of said predetermined width; and
an insulating layer disposed between said conformal layer and said sidewall of said trench.

7. The capacitive element of Claim 6 wherein said layer of a second conductive material comprises a conformal layer of conductive material.

8. The capacitive element of Claim 6 wherein said first conductive material comprises a semiconductor material.

9. The capacitive element of Claim 6 wherein said second conductive material comprises a semiconductor material.

10. The capacitive element of Claim 6 wherein said first and second conductive materials comprise materials of like conductivity type.

11. The capacitive element of Claim 6 wherein said layer of second conductive material is a predetermined resistivity and further comprises a first and second tab such that said first and second tabs may be contacted to obtain both a capacitance and resistance therebetween.

12. A method of forming a resistive element, comprising:
forming a layer of material;
forming a trench of a predetermined width in the layer of material, having first and second sidewalls and a bottom edge; and
forming a layer of resistive material adjacent the sidewalls and the bottom edge of the trench, defining a void area within the trench.

13. The method of forming a resistive element of Claim 12 wherein said step of forming the layer of resistive material comprises forming a conformal layer of a thickness less than one-half of the predetermined width.

14. The method of forming a resistive element of Claim 12 and further comprising the step of forming an insulating layer between the layer of resistive material and the sidewalls of the trench.

15. The method of forming a resistive element of Claim 12 and further comprising the step of forming an insulating layer between the layer of resistive material and the bottom edge of the trench.

16. The method of forming a resistive element of Claim 12 wherein said void area comprises a first void area, and further comprising the step of forming an insulating layer within the first void area and adjacent the layer of resistive material, defining a second void area.

17. The method of forming a resistive element of Claim 12 and further comprising the step of forming an insulating region within the second void area.

FIG. 1

FIG. 3

FIG. 2a

FIG. 4

FIG. 2b

FIG. 6

FIG. 5